**Europäisches Patentamt**

**European Patent Office**

**Office européen des brevets**

(19)

(11) Veröffentlichungsnummer: **0 001 794**
**B1**

(12)

# EUROPÄISCHE PATENTSCHRIFT

(21) Anmeldenummer: **78101194.5**

(22) Anmeldetag: **23.10.78**

(51) Int. Cl.³: **H 01 L 21/18**

(54) Verfahren zum Herstellen einer gegetterten Halbleiterscheibe

(30) Priorität: **31.10.77 US 847383**

(43) Veröffentlichungstag der Anmeldung:
**16.05.79 Patentblatt 79/10**

(45) Bekanntmachung des Hinweises auf die Patenterteilung:
**10.12.80 Patentblatt 80/25**

(84) Benannte Vertragsstaaten:
**DE FR GB**

(56) Entgegenhaltungen:
**DE - A - 2 013 224**
**DE - A - 2 114 556**
**US - A - 3 905 162**
**US - A - 3 923 567**

(73) Patentinhaber: **International Business Machines
Corporation
Armonk, N.Y. 10504 (US)**

(72) Erfinder: **Edmonds, Harold Donald
Hausner Drive, Box 77, Rd 6
Hopewell Junction NY 12533 (US)
Markovits, Gary
7 Spratt Avenue
Poughkeepsie, NY 12603 (US)**

(74) Vertreter: **Böhmer, Hans Erich, Dipl.-Ing.
Schönaicher Strasse 220
D - 7030 Böblingen (DE)**

Courier Press, Leamington Spa, England.

**0 001 794**

## Verfahren zum Herstellen einer gegetterten Halbleiterscheibe

Die Erfindung betrifft ein Verfahren zum Herstellen einer gegetterten Halbleiterscheibe, bei dem eine erste Oberfläche einer Halbleiterscheibe mit zwei planparallelen, ebenen Oberflächen zur Erzeugung einer an die erste Oberfläche anschließenden, mit kristallographischen Schäden versehenen Halbleiterschicht mittels einer rotierenden Schleifvorrichtung geschliffen und die Halbleiterscheibe zur Getterung in einer inerten Atmosphäre erwärmt und nachfolgend innerhalb einiger Minuten abgekühlt wird. Ein derartiges Verfohren ist aus der DE—AS 2 013 224 bekannt.

Es ist bereits eine Anzahl von Verfahren bekannt, die eine Getterung in Halbleitermaterialien, wie z. B. aus Silicium bestehenden Halbleiterscheiben liefern, so daß die mit diesen Materialien erzielbare Ausbeute an integrierten Schaltungen erhöht wird. Unter diesen Verfahren befindet sich auch ein Verfahren, bei dem auf der Rückseite der Halbleitermaterialien mechanische Beschädigungen der Kristallstruktur eingeführt werden. Diese kristallographischen Schäden wurden dabei entweder vor oder nach ‚der Herstellung der Halbleiterschaltungen erzeugt. Außerdem ist es aus der DE—AS 20 13 224 über den ersten Teil des Anspruchs 1 hinaus bekannt, daß die die Getterung bewirkende Erwärmung bei einer Temperatur von 1050°C vorzunehmen ist. Aus der US—A 3 923 567 ist es bekannt, nach dem thermischen Gettervorgang die mit Schadstellen angereicherten Oberflächenschichten eines Halbleiterplättchens zu entfernen.

Mit zunehmender Dichte der auf einer vorgegebenen Fläche einer Halbleiterscheibe untergebrachten Bauelemente erhöht sich auch die Notwendigkeit, ein Halbleitermaterial zu besitzen, bei dem die Dichte dieser Schäden geringer ist. Gleichzeitig müssen aber auch die rein körperlichen Eigenschaften der Materialien, wie beispielsweise die Welligkeit, Glätte oder Ebenheit der Oberflächen in engeren Grenzen gehalten werden. Ein Getter-Verfahren muß daher nicht nur eine zuverlässige Verbesserung der elektrischen Eigenschaften durch Verringerung der Dichte dieser kristallographischen Schäden leifern, sondern muß auch gleichzeitig die Unversehrtheit der Abmessungen des Materials sicherstellen. Dies wird insbesondere dann schwieriger, wenn beispielsweise Halbleiterscheiben mit einem Durchmesser von 7,5 cm oder mehr für die Herstellung von integrierten Schaltungen verwendet werden. Man hat beispielsweise zur Verbesserung der elektrischen Eigenschaften von Silicium-Scheiben diese auf der Rückseite geläppt, auf der Vorderseite poliert und bei hohen Temperaturen (1250°C) angelassen, doch hat man dabei festgestellt, daß sich während der Verarbeitung ungewöhnlich hohe Verwerfungen ergeben. Außerdem stellt die rauhe Rückseite der Halbleiterscheiben mögliche Einfangstellen für bei der Herstellung der Halbleiterbauelemente verwendeten verschiedenen Bearbeitungsflüssigkeiten dar, wodurch sich eine Verunreinigung der Halbleiterscheibe ergeben kann.

Das Verfahren gemäß der Erfindung soll eine Herstellung von Halbleiterscheiben mit verbesserten elektrischen Eigenschaften ermöglichen und gleichzeitig sicherstellen, daß bei der Herstellung von integrierten Schaltungen hoher Dichte die Abmessungen beibehalten werden.

Das erfindungsgemäße Verfahren zeichnet sich dadurch aus, daß bei einem Verfahren der eingangs genannten Art vor dem Schleifen die beim Zersägen des Kristalls entstandenen Beschädigungen zur Erzeugung der zwei planparallelen Oberflächen entfernt werden, daß zum Schleifen ein Schleifmittel mit einer Körnung zwischen 100 und 1200 verwendet wird, daß das Erwärmen so lange auf einer so hohen Temperatur durchgeführt wird, daß gleichzeitig mit dem Gettern durch das Schleifen hervorgerufene Spannungszustände beseitigt werden, und daß die Oberflächen der Halbleiterscheibe in einem derartigen Maße poliert werden daß die erste Oberfläche im wesentlichen glatt ist und eine Restschicht der mit kristallographischen Schäden versehenen Halbleiterschicht für die Getterung während der weiteren Verarbeitung der Halbleiterscheibe verbleibt und daß eine glatte zweite Oberfläche hergestellt wird, an die sich ein im wesentlichen keine kristallographischen Schäden aufweisender Halbleiterbereich anschließt. Besondere Ausführungsarten dieser Erfindung sind in den Unteransprüchen gekennzeichnet.

Ein Weg zur Ausführung der Erfindung wird nunmehr in Verbindung mit der Zeichnung im einzelnen beschrieben.

In der Zeichnung zeigen

Fig. 1 stark vereinfacht eine Anordnung zur Bildung einer kristallographische Schäden aufweisenden Schicht mit dem Verfahren gemäß der Erfindung und

Fig. 2 eine Draufsicht auf das Muster von kristallographischen Schäden in der Halbleiterscheibe.

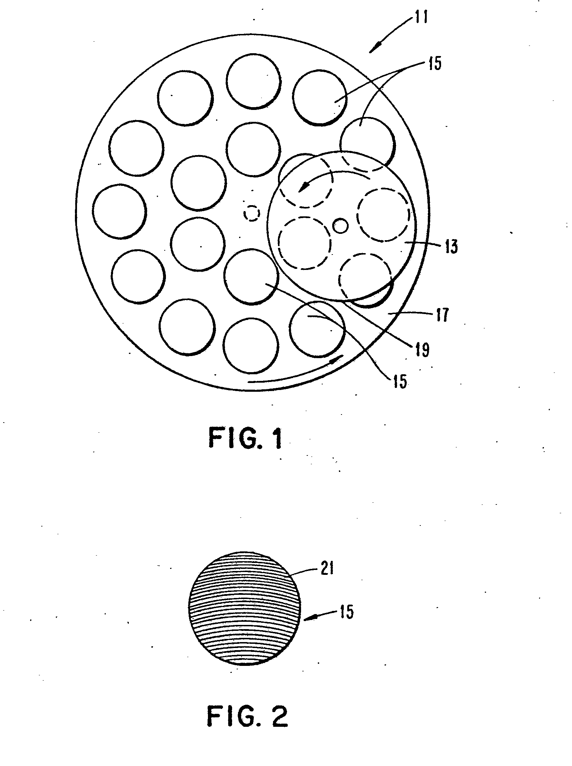

Die bei dem erfindungsgemäßen Verfahren als besonders wirksam erkannte Art der kristallographischen Beschädigung wird durch eine rotierende Schleifvorrichtung erzeugt. Ein Beispiel einer dafür geeigneten Vorrichtung ist schematisch in Fig. 1 gezeigt. Die Schleifvorrichtung 11 wird gewöhnlich dazu benutzt, die beim Zersägen des Kristalls hervorgerufenen Beschädigungen zu beseitigen, wodurch eine Halbleiterscheibe mit zwei ebenen, parallelen Oberflächen entsteht. Die Schleifvorrichtung 11 weist eine rotierende Schleifscheibe 13 auf, deren Durchmesser viel größer ist als der Durchmesser der Halbleiterscheiben 15. Die Halbleiterscheiben 15 werden auf einem rotierenden Tisch 17 stationär gehalten, der die Halbleiterscheiben unter die Schleifscheibe 13 befördert. Es ist besonders günstig die Schleifscheibe 13 um einige Grade gegen die Waagerechte zu neigen, so daß die Vorderkante 19 die Halbleiterscheiben 15 berührt. Das auf den Halbleiterscheiben 15 erzeugte Muster von Beschädi-

# 0 001 794

gungen hängt im allgemeinen etwas davon ab, wo jede Halbleiterscheibe 15 auf dem Tisch 17 angebracht ist, besteht im allgemeinen aber aus einer Folge leicht gekrümmter Linien 21, wie dies Fig. 2 zeigt. Die Höhe der Schleifscheibe 13 über der Oberfläche des Tisches 17 ist einstellbar, so daß damit die durch jeden Durchgang der Halbleiterscheiben 15 unter der Schleifscheibe 13 abtragbare Materialmenge eingestellt werden kann. Normalerweise wird während des Schleifverfahrens eine Schicht mit einer Dicke von etwa 45 $\mu$m in der Weise abgetragen, daß in aufeinanderfolgenden Schritten abnehmend immer geringere Materialmengen in der Weise abgetragen werden, daß durch Grobschleifen 2—3 $\mu$m je Durchgang, durch mittleres Schleifen 1 $\mu$m und durch Feinschleifen 1/2 $\mu$m je Durchgang abgetragen werden. Beim Grobschleifen werden insgesamt 10—20 $\mu$m, beim mittleren Schleifen etwa 15—20 $\mu$m und der Rest durch Feinschleifen und Polieren abgetragen. Die Umlaufgeschwindigkeit des Tisches während des Grobschleifens beträgt etwa 5—10 Umdrehungen pro Minute und beim Feinschleifen 1—3 Umdrehungen pro Minute. Die Umdrehungsgeschwindigkeit der Schleifscheibe liegt im Bereich von 1200 Umdrehungen je Minute. Während des Schleifvorganges wird Wasser als Schmiermittel benutzt. Die Tiefe der kristallographischen Schäden ist eine Funktion der Korngröße der Schleifscheibe. Korngrößen von 100—1200 eines Schleifmaterials, wie z. B. Diamant, können zur Erzeugung von kristallographischen Schäden verwendet werden, d. h. mit einer Korngröße von 100 lassen sich etwa 30—35 $\mu$m und mit einer Korngröße von 1200 etwa 5—10 $\mu$m erzielen. Eine bevorzugte Krongröße des Schleifmittels ist 400, die eine durchschnittliche Tiefe der kristallographischen Schäden von etwa 19 $\mu$m liefert, die sich leicht polieren läßt und damit eine glatte Rückseite liefert, die noch eine restliche Schicht mit kristallographischen Schäden einer Tiefe von 10—12 $\mu$m bestehen läßt.

Um die Getter-Wirkung gemäß der Erfindung zu erhalten, muß die Halbleiterscheibe vor der ersten Oxidation in einer inerten Atmosphäre erhitzt werden. Dabei können Temperaturen zwischen etwa 800 bis 1150°C verwendet werden. Die Dauer der Erhitzung liegt etwa zwischen 1—4 Stunden. Eine Dauer von weniger als 1 Stunde wird wohl nicht die beste Wirkung haben, und eine Dauer der Erwärmung von mehr als 4 Stunden ist überflüssig. Vorzugsweise sollen die Halbleiterscheiben bei atwa 1000°C für etwa 3 Stunden erhitzt werden. Durch die Wärmebehandlung werden außerdem durch das unsymmetrische Muster an kristallographischen Schäden hervorgerufene Spannungszustände ausgeglichen, so daß die Halbleiterscheiben nich nur die Bedingungen für eine geringste Welligkeit bei Beginn der Bearbeitung erfüllen, sondern auch während der Bearbeitung keine Verwerfungen zeigen. Vorzugsweise soll die Erwärmung vor dem Polieren durchgeführt werden, da damit eine unnötige Behandlung der polierten Halbleiterscheibe vermieden wird. Es wurde ferner bei größeren Halbleiterscheiben mit einem Durchmesser von 7.5 cm oder mehr festgestellt, daß noch nicht warm behendelte Halbleiterscheiben durch die auf der Rückseite erzeugten kristallographischen Schäden selbst dann eine so große Durchbiegung aufweisen, wenn die kleine Krongröße 1200 für die kristallographische Schäden aufweisende Schicht benutzt wird, daß eine größere Materialmenge an denjenigen Kanten der Fläche der Halbleiterscheibe abgetragen wird, die über die Polierträgerplatte hinausragen. Damit wird die Oberfläche von der Kante der Halbleiterscheibe her abgeschrägt. Dies ist ungeeignet, weil dadurch lithographische Muster rund um die Kante der Halbleiterscheibe während der Herstellungsverfahren für die Halbleiterschaltungen verzerrt werden und weil so abgeschrägte Halbleiterscheiben die Forderungen an die Einhaltung der Grenzen für ebenen Flächen der Halbleiterscheiben, wie sie für die Herstellung von hochintegrierten Schaltungen hoher Dichte erforderlich sind, nich erfüllen. Obgleich dies durch die Verwendung von dickeren Halbleiterscheiben als üblich vermieden werden kann, so wird doch angenommen, daß es auch durch eine vor dem Polieren erfolgende Hitzebehandlung vermieden werden kann, die die durch das unsymmetrische Muster der kristallographischen Schäden hervorgerufene Durchbiegung beseitigt. Zur Erzielung einer vollständigen Getterwirkung sollten die Halbleiterscheiben vor der Herstellung von Halbleiterschaltungen rasch auf eine Temperatur von weniger als etwa 600°C abgekühlt werden. Das kann dadurch erreicht werden, daß man die Halbleiterscheiben aus dem Ofen in die Endkappe des Ofens abzieht, die bei einer Temperatur von etwa 400°C liegt, so daß die Halbleiterscheiben in etwa 2—3 Minuten sich rasch auf unter 600°C abkühlen.

Das erfindungsgemäße Verfahren leifert eine Halbleiterscheibe, die eine im wesentlichen von Beschädigungen freie Vorderoberfläche aufweist, in der die Halbleiterschaltungen gebildet werden sollen. Außerdem erzielt man dabei eine glatte rückseitige Oberfläche, die jedoch eine Restschicht von kristallographischen Schäden für die Getterung während der Herstellung der Halbleitervorrichtungen aufweist. Dies hat den Vorteil, daß dadurch das Einfangen von Verunreinigungen vermieden wird, die durch Fördereinrichtungen und Bearbeitungslösungen hervorgerufen werden könnten, wenn die Oberfläche rauh und mit Vertiefungen versehen ist. Der Ausdruck glatt soll hier bedeuten, daß die Oberfläche nahezu poliert aussieht und im wesentlichen frei von sichtbaren Rillen, Vertiefungen oder Spuren ist. Die Getterschicht besteht aus einem Netzwerk von im wesentlichen linearen Versetzungen, die aneinander anstoßen. Die dichte der kristallographischen Schäden liegt in der Größenordnung von $1 \times 10^8$ bis $1 \times 10^{10}$/cm². Das Netzwerk ist dabei auf eine Ebene parallel zu und anschließend an die rückwärtige Oberfläche der Halbleiterscheibe beschränkt. Durch die Wärmebehandlung bleibt das Netzwerk auf die Ebene, die sich an die rückwärtige Oberfläche anschließt beschränkt und wandert nicht aus dieser Ebene aus.

Das Verfahren kann auch von dem sogenannten freien Polierverfahren Gebrauch machen, das beispielsweise in IBM Technical Disclosure Bulletin, Band 15, Nr. 6, Seiten 1760—1761, vom November 1972 durch F. Goetz und J. Hause unter dem Titel "Planetary 'Free' Wafer Polisher" oder in der US-Patentschrift 3 691 694 beschrieben ist. Ein geeignetes Polierverfahren ist beispielsweise das Polierverfahren mit Tonerde. Beim Tonerde-Polierverfahren wird eine Poliertrübe benutzt, die ein kolloidales Siliciumdioxyd-Schleifmittel, Natriumdichloroiso-cyanurat als Oxidiermittel und Natriumkarbonat als Basis verwendet. Der Ph-Wert der Poliertrübe liegt unter 10. Bei dem freien Polierverfahren können beide Seiten der Halbleiterscheibe gleichzeitig poliert werden, oder es kann eine Lagerung für die Halbleiterscheibe benutzt werden, so daß dann jeweils nur eine Seite poliert wird, wie dies beispielsweise in IBM Technical Disclosure Bulletin, Band 19, Nr 12, Seite 4592, durch T. B. Free unter dem Titel "Single-Sided Free Polishing" und IBM Technical Disclosure Bulletin, Band 19, Nr. 12, Seiten 4594—4595, Mai 1977, durch G. Markovits und E. Velky unter dem Titel "Free Polishing Apparatus" beschrieben ist. Ein zweistufiges Verfahren, bei dem die vordere Oberfläche durch einseitiges Polieren zum Teil poliert wird, während dann beide Oberflächen gleichzeitig durch doppelseitiges freies Polieren bearbeitet werden, wurde als besonders vorteilhaft dafür festgestellt, daß damit sichergestellt ist, daß die auf der Rückseite befindlichen kristallographischen Schäden wegen unterschiedlicher Geschwindigkeiten bei der Materialabtragung, die bei der Fertigung schon einmal vorkommen können, nicht vollständig entfernt werden. Selbstverständlich könnten beide Seiten auch getrennt poliert werden. Andere Poliervorrichtungen und -verfahren, die eine von Beschädigungen freie vordere Seite und eine glatte Rückseite mit einer Restschicht von kristallographischen Schäden liefern, die eine ausreichende Getterung während der Herstellung der Halbleiterschaltungen liefert, könnte ebenfalls eingesetzt werden.

Das erfindungsgemäße Verfahren wird von der Herstellung der Halbleiterschaltungen durchgeführt. Bei der Erzeugung von aus Silicium bestehenden Halbleiterscheiben wird es nach dem Zersägen des Kristalls und nach der Formung der Halbleiterscheiben eingesetzt. Beispielsweise werden die Halbleiterscheiben zunächst von einem Einkristall abgesägt und dann in einer Schleifvorrichtung auf beiden Seiten geschliffen, bis die Halbleiterscheibe parallele Oberflächen aufweist. Die durch das Schleifen verursachten Oberflächenschäden werden dann durch chemisches Ätzen entfernt. Die Halbleiterscheiben würden dann normalerweise poliert werden. Das Getter-Verfahren kann unmittelbar nach der chemischen Entfernung der Schleifschäden durchgeführt werden, so daß das übliche Herstellungsverfahren für Halbleiterscheiben damit verträglich ist.

Der Erfindung wird durch die nachfolgenden Beispiele weiter erläutert, eine Beschränkung der Erfindung ist damit jedoch nicht beabsichtigt.

Beispiel 1

p-leitende Silicium-Halbleiterscheiben mit 2 Ohm cm spezifischen Widerstand und einem Durchmesser von etwa 8 cm wurden von einem Kristall abgesägt mit einer Dicke von etwa 0.66 ± 0.025 mm. Die abgesägte Halbleiterscheibe wird daraufhin auf beiden Seiten abgeschliffen, und man erhält eine Halbleiterscheibe mit zwei flachen parallelen Oberflächen und einer Dicke von etwa 0.53 mm. Die Kanten der Halbleiterscheiben werden leicht abgeschrägt, um die Zerbrechlichkeit herabzusetzen und werden dann chemisch geätzt, um die durch Schleifen und Abrunden erzeugten Beschädigungen zu beseitigen, wodurch eine Halbleiterscheibe mit einer Dicke von etwa 0.46 mm und zwei ebenen parallelen Oberflächen entsteht. Dies ist ein üblicher Vorgang. Diese abgeätzte Halbleiterscheibe wird dann in eine Schleifvorrichtung eingesetzt und dann wird nur die Rückseite mit einer Diamant-Schleifkorngröße 400 geschliffen, bis die Halbleiterscheibe eine Dicke von 0.42 mm aufweist und Beschädigungen auf der Rückseite mit einer Tiefe von etwa 19 $\mu$m besitzt. Dann wird die Halbleiterscheibe für etwa 3 Stunden bei 1000°C in einer Stickstoffatmosphäre erhitzt und dann schnell aus dem Ofen nach der Ofenendkappe herausgenommen, so daß die Temperatur rasch unter 600°C abkühlt. Dadurch werden die durch die unsymmetrischen kristallographischen Schäden hervorgerufenen Spannungszustände beseitigt und man erreicht damit die Getterung von beliebigen Schadstoffen. Die Halbleiterscheibe wird dann in eine freie Poliervorrichtung in der Weise eingesetzt, daß nur die Vorderseite dem Polierverfahren ausgesetzt ist und mit Aluminiumoxid zur Erzeugung einer polierten, von Beschädigungen freien Oberfläche auf der Halbleiterscheibe poliert, die nunmehr eine Dicke von 0.41 ± 0.01 mm aufweist. Die Halbleiterscheibe wird dann auf eine Trägerplatte aufgesetzt, bei der beide Oberflächen der Halbleiterscheibe dem freien Polierverfahren ausgesetzt sind, worauf beide Seiten gleichzeitig mit Aluminiumoxid oder Tonerde poliert werden. Dadurch wird die rauhe Oberfläche von der Rückseite der Halbleiterscheibe entfernt und Vertiefungen, die möglicherweise Verunreinigungen einfangen können, werden beseitigt, während gleichzeitig eine ausreichende Anzahl kristallographischer Schäden erhalten bleibt, so daß während der Herstellung der Halbleiterschaltungen eine weitere Getterung stattfinden kann. Das Polierverfahren entfernt dabei etwa die Hälfte der Dicke der die kristallographischen Schäden enthaltenden Schicht bis auf eine Resttiefe von etwa 12—13 $\mu$m unter Verwendung einer Schleifscheibe mit einer Korngröße von 400. Wenn man eine Schleifscheibe mit einer Korngröße 1200 verwendet, dann wäre die restliche Tiefe der kristallographischen Schäden etwa 2—3 $\mu$m. Danach beträgt die Dicke der Halbleiterscheibe etwa 0.394 ± 0.013 mm. Halbleiterscheiben wurden probeweise durch das Verfahren gemäß Beispiel 1 erzeugt und auf Verwerfungen und Ebenheit mittels Lichtinterferenz-Verfahren untersucht, wobei die Interferenzringe gezählt wurden. Die Halbleiterscheibe wird an ihrer Unterseite durch eine Vakuumhalterung für die Messung der Flachheit festgehalten. Die durchschnittliche Flachheit betrug 0.008 mm innerhalb eines Bereiches von 0.006 mm bis etwa 0.01 mm, wenn alle Randbereiche an der Kante der Halbleiterscheibe mitgerechnet werden. Die durchschnittliche Wölbung betrug etwa 0.74 mm im Bereich zwischen 0.061 mm und 0.076 mm. Zwei Gruppen von Kontrollscheiben wurden gemäß Beispiel 1 bearbeitet, wobei lediglich die Wärmebehandlung fortgelassen wurde. Sie hatten praktisch die gleiche Flachheit wie die einer Wärmebehandlung unterzogenen Halbleiterscheiben, jedoch betrug die durchschnittliche Welligkeit der beiden Probengruppen 0.043 mm bzw. 0.039 mm. 10 nach dem Verfahren gemäß Beispiel 1 hergestellte Probescheiben wurden auf ihre elektrischen Eigenschaften gemessen, und es wurde die Dichte der kristallographischen Schäden bestimmt. Die Halbleiterscheiben wurden oxidiert, und es wurden auf der Vorderseite 120 Aluminium-Punkte mit einem Durchmesser von 1.5 mm niedergeschlagen. Jeder Punkt wurde für sich elektrisch geprüft, und aus den Ergebnissen wurde die Dichte der kristallographischen Schäden berechnet. Die Dichte der kristallographischen Schäden auf der Vorderseite der Halbleiterscheiben ging von 2 bis 29 kristallographischen Schäden je cm² mit einem durchschnittlichen Wert von etwa 7 Schäden je cm². 12 Kontrollscheiben wurden nach dem chemischen Abätzen auf normale Weise zweiseitig poliert. 3 Halbleiterscheiben waren völlig unbrauchbar (mehr als 500 Defektstellen je cm²). Die anderen 9 Halbleiterscheiben wiesen Dichten ihrer kristallographischen Schäden von etwa 6 bis etwa 190 je cm² mit einem Durchschnitt von über 70 kristallographischen Schäden je cm² auf der Vorderseite auf.

Beispiel 2

Chemisch dünner gemachte P-leitende Silicium-Halbleiterscheiben von 10—20 Ohm/cm mit einem Durchmesser von 57 mm (Typ A) und P-leitende Silicium-Halbleiterscheiben von 57 mm Durchmesser und 2—4 Ohm/cm (Typ B) wurden mit einer Schleifvorrichtung mit Diamantschleifstaub der Körnungen 400, 200 bzw. 100 nur auf der Rückseite geschliffen, wodurch in verschiedenen Probescheiben unterschiedliche Tiefen der kristallographischen Schäden erzeugt wurden. Die Probescheiben wurden dann auf beiden Seiten mit Aluminiumoxid poliert, so daß auf der Rückseite eine etwa 10 $\mu$m tiefe kristallographische Schäden aufweisende Schicht verblieb. Der Zustand der Rückseite reichte dabei von einem nahezu polierten Aussehen für die Schleifscheibe mit 4ooer Körnung bis zu einer stark zerklüfteten Oberfläche mit einer Schleifscheibe mit 100er Körnung. Die Kontrollscheiben wurden nicht beschädigt, aber auf beiden Seiten poliert. Die beschädigten Halbleiterscheiben wurden in einem Ofen für drei Stunden in einer Stickstoffatmosphäre bei 1000°C erhitzt und dann für eine Abkühlung unter 600°C aus dem Ofen herausgenommen. Sie wurden dann zusammen mit den Kontrollscheiben wieder in den Ofen eingegeben und zur Bildung einer Oxidschicht mit einer Dicke von etwa 5000 Å = 0.5 $\mu$m oxidiert. Anschließend wurden 120 Aluminiumpunkte mit einem Durchmesser von 1.52 mm niedergeschlagen und geprüft. Die Ergebnisse sind in den Tabellen I und II zusammengefaßt, wo die Dichte der auf der Vorderseite vorhandenen kristallographischen Schäden aus den elektrischen Untersuchungen berechnet ist.

TABELLE I

Typ A
Kristallographische Schäden/cm²

| Schleifscheibe | Probe | auf der Rückseite beschädigte Scheiben | Kontrollscheiben |
|---|---|---|---|
| Körnung 400 | 1 | 1 | 145 |
|  | 2 | 1 | 78 |
| Körnung 240 | 1 | 0 | 131 |
|  | 2 | 1 | 105 |
| Körnung 100 | 1 | 1 | 52 |
|  | 2 | 2 | 60 |
|  |  | Durchschn. = 1 | Durchschnitt = 95 |

## 0 001 794

### TABELLE II

Typ B
Kristallographische Schäden/cm²

| Schleifscheibe | Probe | auf der Rückseite beschädigte Scheiben | Kontrollscheiben |
|---|---|---|---|
| Körnung 400 | 1 | 1 | 24 |
| | 2 | 2 | 91 |
| Körnung 240 | 1 | 2 | 9 |
| | 2 | 2 | 105 |
| Körnung 100 | 1 | 0 | 52 |
| | 2 | 0 | 73 |
| | | Durchschn. = 1 | Durchschnitt = 59 |

Probescheiben, die in genau der gleichen Weise, jedoch mit einer Wärmebehandlung von nur einer Stunde bearbeitet wurden, lieferten ein ähnliches Ergebnis mit einer durchschnittlichen Dichte von kristallographischen Schäden von etwa 8.

### Beispiel 3

Chemisch dünner geätzte Silicium-Halbleiterscheiben der Typen A und B gemäß Beispiel 2 wurden in einer Schleifvorrichtung nach dem chemischen Ätzen auf der Rückseite mit einer Diamantschleifscheibe mit Körnung 400 beschädigt. Einige der Probescheiben wurden für 3 Stunden in Stickstoff erhitzt und durch Herausnehmen aus dem Ofen rasch abgekühlt. Andere Probescheiben wurden ohne Herausnehmen aus dem Ofen oxidiert, während die Temperatur auf 1000°C gehalten wurde. Andere Probescheiben wurden überprüft, die überhaupt keine Wärmebehandlung erfahren hatten. In jedem Fall wurden auch Kontrollscheiben untersucht, die auf der Rückseite keine kristallographische Schäden enthaltende Schicht aufweisen. Die Ergebnisse der Überprüfung auf die Dichte der kristallographischen Schäden zeigt Tabelle III.

### TABELLE III

| Verfahren | | Kristallographische Schäden/cm² (Bereich) | |
|---|---|---|---|
| | | Tpy A | Typ B |
| beschädigen, | aufheizen, abkühlen | 1—10 | 4—5 |
| | aufheizen, abkühlen | 25—91 | 14—50 |
| beschädigen, | aufheizen, nicht abkühlen | 6—18 | 11—14 |
| | aufheizen, nicht abkühlen | 10—27 | 7—9 |
| nur beschädigen | | 50—>500 | —— |
| nicht behandelt | | 79 | 16—22 |

Aus Tabelle III sieht man, daß die beschädigten, aufgeheizten und rasch abgekühlten Halbleiterscheiben im Vergleich mit den verschiedenen Kontrollscheiben verbesserte Ergebnisse lieferten.

Durch die Erfindung wurde also ein Verfahren für die Erzeugung von Halbleiterscheiben geschaffen, die bessere elektrische Eigenschaften aufweisen, wobei das Verfahren unter Benutzung üblicher Vorrichtungen mit der normalen Herstellung von Halbleiterscheiben verträglich ist. Die Halbleiterscheiben genügen strengsten Anforderungen bezüglich ihrer Abmessungen und weisen eine Restschicht mit kristallographischen Schäden auf, die während der Herstellung von Halbleiterschaltungen eine zusätzliche Getterung liefern.

**Patentansprüche**

1. Verfahren zum Herstellen einer gegetterten Halbleiterscheibe, bei dem eine erste Oberfläche einer Halbleiterscheibe mit zwei planparallelen, ebenen Oberflächen zur Erzeugung einer an die erste Oberfläche anschließenden, mit kristallographischen Schäden versehenen Halbleiterschicht mittels einer rotierenden Schleifvorrichtung geschliffen und die Halbleiterscheibe zur Getterung in einer inerten Atmosphäre erwärmt und nachfolgend innerhalb einiger Minuten abgekühlt wird, dadurch gekennzeichnet, daß vor dem Schleifen die beim Zersägen des Kristalls entstandenen Beschädigungen zur Erzeugung der zwei planparallelen Oberflächen entfernt werden, daß zum Schleifen ein Schleifmittel mit einer Körnung zwischen 100 und 1200 verwendet wird, daß das Erwärmen so lange auf einer so hohen Temperatur durchgeführt wird, daß gleichzeitig mit dem Gettern durch das Schleifen hervorgerufene Spannungszustände beseitigt werden und daß die Oberflächen der Halbleiterscheibe in einem derartigen Maße poliert werden, daß die erste Oberfläche im wesentlichen glatt ist und eine Restschicht der mit kristallographischen Schäden versehenen Halbleiterschicht für die Getterung während der weiteren Verarbeitung der Halbleiterscheibe verbleibt und daß eine glatte zweite Oberfläche hergestellt wird, an die sich ein im wesentlichen keine kristallographischen Schäden aufweisender Halbleiterbereich anschließt.

2. Verfahren nach Anspruch 1, dadurch gekennzeichnet, daß als Halbleitermaterial Silicium verwendet wird.

3. Verfahren nach Anspruch 1, dadurch gekennzeichnet, daß als Schleifmittel Diamant verwendet wird.

4. Verfahren nach Anspruch 1, dadurch gekennzeichnet, daß die Erwärmung nach dem Schleifen, aber vor dem Polieren vorgenommen wird.

5. Verfahren nach Anspruch 1, dadurch gekennzeichnet, daß die Erwärmung in einem Ofen bei etwa 800°C bis 1150°C für eine Dauer von 1—4 Stunden in einer Stickstoffatmosphäre durchgeführt wird und daß anschließend die Halbleiterscheibe durch Herausnehmen aus dem Ofen auf eine Temperatur unterhalb von etwa 600°C abgekühlt wird.

6. Verfahren nach den Ansprüchen 1 bis 5, dadurch gekennzeichnet, daß die Halbleiterscheibe mit Aluminiumoxid frei poliert wird.

7. Verfahren nach Anspruch 6, dadurch gekennzeichnet, daß beim Polieren in einer ersten Stufe zunächst die zweite Oberfläche der Halbleiterscheibe zur Bildung eines an die zweite Oberfläche angrenzenden Bereichs ohne kristallographische Schäden frei poliert wird und daß anschließend in einer zweiten Stufe die erste und die zweite Oberfläche gleichzeitig derart poliert werden, daß auf der zweiten Oberfläche die kristallographische Schäden aufweisende Schicht mit einer Dicke von etwa 10—12 $\mu$m entsteht.

**Claims**

1. Process for making a gettered semiconductor wafer, where a first surface of a semiconductor wafer with two flat parallel faces is ground by means of rotating abrasive means to produce a semiconductor layer adjacent to the first face and having crystallographic damages, and where for gettering the semiconductor wafer is heated in an inert atmosphere and subsequently cooled for some minutes, characterized in that prior to grinding the damage caused by the cutting of the crystal to form the two flat parallel faces is removed, that for grinding abrasive means with a grit size between 100 and 1200 are used, that heating takes place for such a time and at such a high temperature that simultaneously with gettering stresses caused by the grinding are relieved, and that the surfaces of the semiconductor wafer are polished such that the first surface is substantially smooth with a residual layer of the semiconductor layer of crystallographic damage being retained, for the gettering during further processing of the semiconductor wafer, and that a polished second surface is made adjacent to a substantially damage-free semiconductor area.

2. Process as claimed in claim 1, characterized in that the semiconductor material is silicon.

3. Process as claimed in claim 1, characterized in that the abrasive means is diamond.

4. Process as claimed in claim 1, characterized in that heating takes place after grinding but before polishing.

5. Process as claimed in claim 1, characterized in that heating takes place in a furnace at approximately 800°C to 1150°C for a time of 1 to 4 hours in a nitrogen atmosphere, and that subsequently the semiconductor wafer is cooled to a temperature of less than 600°C approximately by removing it from the furnace.

6. Process as claimed in claims 1 to 5, characterized in that the semiconductor wafer is polished by free polishing with aluminum oxide.

7. Process as claimed in claim 6, characterized in that in a first polishing stage the second face of the semiconductor wafer is polished by free polishing to form a damage-free area adjacent to the second face, and that subsequently in a second stage the first and the second faces are simultaneously polished in such a manner that on the second face there forms the layer of crystallographic damage with a density of approximately 10 to 12 $\mu$m.

# 0 001 794

**Revendications**

1. Procédé pour fabriquer une tranche semi-conductrice ayant des capacités de piégeage dans lequel une première surface d'une tranche semi-conductrice ayant deux surfaces planes et parallèles, est meulée au moyen d'un dispositif de meulage rotatif afin de produire une couche semi-conductrice avec des endommagements cristallographiques, au voisinage de la première surface, et dans lequel la tranche semi-conductrice est chauffée dans une atmosphère inerte et ensuite refroidie pendant quelques minutes pour obtenir l'effet de piégeage, caractérisé en ce que, l'on supprime, avant le meulage, l'endommagement provoqué par le sciage du cristal pur obtenir les deux surfaces planes et parallèles, que l'on utilise, pour le meulage, un produit abrasif ayant une granulation entre 100 et 1200, que l'on chauffe pendant un temps assez long et à une température assez élevée pour que le piégeage supprime en même temps les états de tension provoqués par le meulage, que l'on polit les surfaces de la tranche semi-conductrice de façon à obtenir la première surface essentiellement lisse et à conserver en profondeur de la surface de la couche semi-conductrice des endommagements cristallographiques pour le piégeage pendant le traitement ultérieur de la tranche semi-conductrice, et à produire une deuxième surface lisse qui est essentiellement dépourvue d'endommagements cristallographiques.

2. Procédé selon la revendications 1, caractérisé en ce que le matériel semi-conducteur utilisé est le silicium.

3. Procédé selon la revendication 1, caractérisé en ce que le moyen abrasif utilisé est le diamant.

4. Procédé selon la revendication 1, caractérisé en ce que le chauffage a lieu après le meulage mais avant le polissage.

5. Procédé selon la revendication 1, caractérisé en ce que le chauffage a lieu dans un four à une température d'environ 800°C à 1150°C pendant une durée de 1 à 4 heures dans une atmosphère d'azote et que la tranche semi-conductrice est ensuite enlevée du four pour être refroidie à une température en-dessous de 600°C.

6. Procédé selon l-une quelconque des revendications 1 à 5, caractérisé en ce que la tranche semi-conductrice est polie selon le procédé dit polissage libre avec de l'oxyde d'aluminium.

7. Procédé selon la revendication 6, caractérisé en ce que pendant une première phase de polissage la seconde surface de la tranche semi-conductrice est polie selon le procédé dit polissage libre pour former une région dépourvue d'endommagements cristallographiques, adjacente à la seconde surface, et qu'ensuite, dans une deuxième phase, la première et la seconde surfaces sont simultanément polies de façon à obtenir sur la seconde surface la couche avec des endommagements cristallographiques d'une épaisseur d'environ 10 à 12 $\mu$m.

8

FIG. 1

FIG. 2